Europäisches Patentamt

European Patent Office

Office européen des brevets

(19)

(11) **EP 1 473 769 A2**

(12) **EUROPEAN PATENT APPLICATION**

(43) Date of publication:
**03.11.2004 Bulletin 2004/45**

(51) Int Cl.7: **H01L 23/29**

(21) Application number: **04009411.2**

(22) Date of filing: **21.04.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(30) Priority: **28.04.2003 US 425894**

(71) Applicant: **Northrop Grumman Corporation
Los Angeles, CA 90067-2199 (US)**

(72) Inventors:
• **Starkovich, John, A.
Redondo Beach, CA 90278 (US)**

• **Akerling, Gershon
Culver City, CA 90230 (US)**
• **Eaton, Larry, R.
Huntington Beach, CA 92649 (US)**

(74) Representative: **Schmidt, Steffen J., Dipl.-Ing.
Wuesthoff & Wuesthoff,
Patent- und Rechtsanwälte,
Schweigerstrasse 2
81541 München (DE)**

(54) **Low thermal expansion adhesives and encapsulants for cryogenic and high power density electronic and photonic device assembly and packaging**

(57) Filled composite compositions can be used as encapsulants, underfill materials, and potting materials in electronic and optical packages that are subjected to a wide temperature range. The composites contain a matrix and a filler composition. In a preferred embodiment, the matrix is an organic material. The filler composition contains particles of a material that have a negative coefficient of thermal expansion. The filler composition contains particles having a wide range of sizes. Furthermore, the particles exhibit a non-normal, for example, log normal or power-law, particle distribution. The non-normal size distribution of the particles enables the filler composition to be formulated at high levels into organic matrices, resulting in composites that have very low coefficient of thermal expansion to match those of the semiconductor materials in the electronic package or optical components in an optical assembly.

**EP 1 473 769 A2**

**Description**

BACKGROUND OF THE INVENTION

1. Field of the Invention

The present invention relates to filled organic composites as adhesives and encapsulants for assembly and packaging electronic, optical, and photonic devices. More specifically, the invention relates to composites having a low coefficient of thermal expansion matched to other components for assembling and packaging high reliability electronic, optical, and photonic devices and components.

2. Discussion of the Related Art

Superconductor and semiconductor integrated electronic circuits contain thin planar chips, substrates, and other packaging materials made from a variety of dielectric, semiconducting, and metallic materials, possessing different thermal conductivity and expansion properties. The chips are typically about a centimeter in size and can contain millions of passive and active electronic elements (for example, transistors, capacitors, inductors, etc) and electrical current traces on a single chip. To make useful superconductor and semiconductor integrated circuits, the chip must be bonded to a substrate, thermally connected to a package to dissipate heat generated during operation, electrically connected to an external circuit, and encapsulated to protect it from the environment. In conventional packaged circuits, electrical leads are brought out to pads for connection to the external circuits. In higher level performing devices, multiple planar wafers and chips may be arranged laterally adjacent to each other, or stacked vertically in 2-50 or more layers within one module or package, to provide for higher overall circuit density and performance. These chips need to be physically bonded to a substrate. With the vertical stack arrangement, these layers need to be bonded to the layers above and below. An underfill material is sometimes used to bond the chip to a thermally conductive material that will dissipate heat generated.

Highly integrated circuits such as central processor units used for computing, high power transistors, and switching devices generate a relatively high amount of heat during operation. The heat must be dissipated to prevent overheating. Similarly, some electrical and electronic devices that need to operate under cryogenic conditions for the proper function, such as superconductor and certain semiconductor devices, may dissipate relatively small absolute amounts of heat. This heat nevertheless needs to be dissipated in order to maintain the devices' proper cryogenic operating temperature. In addition, the relatively large changes in temperature cause the materials in the chip and its associated packaging materials to undergo expansion and contraction along with heating and subsequent cooling. The temperatures to which these different circuits and devices are subjected during packaging and operation extend from below 4 K to above 500K.

The chips and substrate materials are typically made of materials having low thermal expansion. The semiconductor materials, such as Si for example, typically have very low coefficients of thermal expansion, on the order of two to three ppm/K. As such, they do not expand or contract as much when heated and cooled in the environments noted above. On the other hand, typical organic resins used to formulate bonding and underfill materials, encapsulants, and potting compounds have coefficients of thermal expansion on the order of 30-400 ppm/K. When such materials of widely differing coefficients of thermal expansion are in contact and the system is subjected to cold or heat, the individual components experience differential expansion and varying amounts of stress. If the encapsulant in a package moves relative to wires or contacts attached to the chip, the wires or contacts may be pulled loose and a debond may result. Differential expansion may also cause stress at other surfaces that are bonded to one another causing cracking and fracture. For example, changes in temperature can also create a shearing stress that can result in delamination and in peeling contacts from chips and substrates. For these reasons, it is highly desirable to use bonding agents, underfill materials, and encapsulants that have a coefficient of thermal expansion closely matched to that of the substrate, semiconductor, or superconductor materials which are used for making planar, stacks, or sandwich structures.

Generally, encapsulating materials are prepared by adding a filler material to a matrix material. In the case of organic matrix materials, it is common to use as filler particles materials that have lower coefficient of thermal expansion than the matrix. Recently, a number of groups have described particles of materials that have negative coefficient of thermal expansion; that is they contract when heated and expand when cooled. See for example, Sleight U.S. Patent 5,322,559, Sleight et al. U.S. Patent 5,919,720, and Merkel U.S. Patent 6,187,700, the disclosures of which are incorporated by reference. Such materials exhibit coefficient of thermal expansion on the order of negative 5 to negative 10 ppm/K. By a rule of mixtures calculation, it can be seen that such materials would have to be loaded into an organic matrix at levels well above 60 volume percent in order to prepare a composite with a coefficient of thermal expansion closely matched to the low to near-zero CTE's of the semiconductors.

When conventional fillers are formulated into organic matrices at levels above about 50% by volume, the viscosity of the composite tends to rise so high as to render it unprocessable. Accordingly, the reports noted above of the negative CTE materials have not taught how to formulate them at levels of above 60% so as to achieve much lower to near zero CTE in the resulting composite.

## SUMMARY OF THE INVENTION

The present invention provides filled composite compositions that can be used as adhesives, encapsulants, underfill materials, and potting materials in electronic packages and for assembling optical and photonic devices. The composites contain a matrix and a filler composition. In a preferred embodiment, the matrix is an organic material. The filler composition contains particles of a material that has a negative coefficient of thermal expansion. The filler composition contains particles having a tailored range of sizes. Preferably the number distribution is skewed and extends over one or two orders of magnitude. In one embodiment, the particles exhibit non-normal, for example, a log normal, exponential, power-law, or multi-modal, particle number distribution. These non-normal size distributions of the particles enable the filler composition to be formulated at higher levels into organic matrices, resulting in composites that have manageable viscosity properties of mixture while achieving lower coefficients of thermal expansion to match those of the materials used in the electronic device assembly and packaging as well as for assembly of optical and photonic devices and components.

Additional objects, advantages and features of the present invention will become apparent from the following description and appended claims, taken in conjunction with the accompanying drawings.

## BRIEF DESCRIPTION OF THE DRAWINGS

The present invention will become more fully understood from the detailed description and the accompanying drawings, wherein:

Figure 1 illustrates a log normal distribution of particles of the invention;

Figure 2 illustrates a device used to prepare filled composites of the invention; and

Figure 3 illustrates an electronic package.

## DETAILED DESCRIPTION OF THE INVENTION

The following description of the preferred embodiment(s) is merely exemplary in nature and is in no way intended to limit the invention, its application, or uses.

In one embodiment, the invention provides a filled composite composition, comprising a matrix and a filler composition. The filler composition contains particles of a material having a low coefficient of thermal expansion, or CTE. In a preferred embodiment, the CTE of the particles is 5 ppm/K or less. In another preferred embodiment, the particles have a negative CTE. Filled composite compositions using suitable volume distributions of these characteristic materials can be formulated containing high levels of the filler. In a preferred embodiment, composites formulated from them can have a net CTE of near or equal to zero. For example, composites with a CTE of 7 ppm/K or less, 5 ppm/K or less, or 3 ppm/K or less may be formulated. In another embodiment, composites with a zero or negative CTE may be formulated.

The particles of the filler composition are characterized by size distributions exemplified by volume distributions and number distributions. The particle volume distribution $fv(D)$ gives the fraction of the total filler volume contributed by particles of size $D$. The particle number or count distribution $fn(D)$ gives the fraction of the total number of filler particles contributed by particles of size $D$. These two distributions are related through $fv(D) = fn(D) \times volume(D) \times norm$ where $volume(D)$ is the volume of a particle with size $D$ and $norm$ is a normalization factor. In general, these two related distributions will have different modes (peak values) and skewnesses. The skewnesses and modes of the particle number and volume distributions should be tailored in order to enable higher filler packing densities.

In a preferred embodiment, the filler particle number and volume distributions are tailored in order to achieve high filler packing density. The optimal particle distributions depend on particle geometry, fluid (matrix) properties, and particle absolute size range. In one embodiment, particle distributions are used that are skewed in such a way that the majority of particles are larger than those of the mode. In addition, if the volume distribution mode occurs at a larger value of particle size than the number distribution mode, then most of the filler volume will be contributed by these particles (i.e., those with sizes greater than the number density mode). Examples of distributions that can be appropriately tailored toward the desired distributions include non-normal distributions such as log-normal, exponential, power-law, or multi-modal.

Composites of the invention having CTE near zero are useful in preparing electronic packages and for assembling optical and photonic devices that are subjected to large temperature differences. They serve as underfill, encapsulants, potting materials and the like. They are particular useful in electronic packages containing integrated circuits and optical components made of materials that exhibit very low CTE such as silicon for example. In a preferred embodiment, the CTE of the composites closely matches or is identical with that of the integrated circuit materials.

Preferred adhesive or encapsulant materials contain matrixes made from such materials as epoxies, polyamides, polyimides, and silicone. These materials generally have fairly large CTE's, on the order of 30-400 ppm/K. As such, the matrix materials exhibit a large mismatch with typical semiconductor materials used for integrated circuits such as silicon, germanium, gallium arsenide, InP, and InSb, and with typical optical and optical-assembly materials such as quartz and invar.

Preferred filler materials for the composites of the invention include those having a negative CTE. Preferred negative CTE materials are those that exhibit isotropic contraction upon heating. It is also preferred that the contraction upon heating take place over a temperature range that includes ambient conditions.

Such materials having negative CTE are known in the art. Non-limiting examples include $ZrVPO_7$, $HfVPO_7$ and related compounds such as disclosed in U.S. Patent Nos. 5,322,559 and 5,433,778 by Sleight, the disclosures of which are incorporated by reference in their entireties. These materials include compounds that satisfy the general formula $A_{1-y}^{4+} A_y^{1+} A_y^{3+} V_{2-x} P_x O_7$, where y may vary from about 0 to about 0.4 and more preferably varies from about 0.1 to about 0.2. X may vary from about 0.1 to about 1.9, more preferably from about 0.5 to about 1.5. In a preferred embodiment, x is about 1. $A^{4+}$ is selected from the group consisting of hafnium, zirconium, $Zr_a M_b$, $Hf_a M_b$, and mixtures thereof. Generally, the sum of a+b is about 1. M is selected from the group consisting of Ti, Ce, Th, U, Mo, Pt, Pb, Sn, Ge, and Si. $A^{1+}$ represents an alkali metal and $A^{3+}$ represents a rare earth metal.

Other materials having a negative CTE include zirconium tungstate ($ZrW_2O_8$) and hafnium tungstate ($HfW_2O_8$), such as disclosed in Sleight, et al. U.S. Patent 5,514,360, herein incorporated by reference.

Other non-limiting examples of negative CTE materials include blends of compounds $M_2B_3O_{12}$ having a negative CTE and a second phase of a composition $AX_2O_8$. M is selected from the group including aluminum, scandium, indium, yttrium, the lanthanide metals, zirconium and hafnium; B is selected from the group consisting of tungsten, molybdenum and phosphorus; A is zirconium or hafnium; and X is tungsten or molybdenum. Such materials are described in Merkel, U.S. Patent 6,187,700, the disclosure of which is incorporated by reference.

To make the filled composite compositions of the invention, a filler composition containing particles of the negative CTE material are combined into a matrix. The CTE of the resulting composites can be approximately estimated by a simple rule of mixtures. For example, if $CTE_m$ is the CTE of the matrix and $CTE_f$ is the CTE of the filler particles, then the CTE of the composite $CTE_c$ can be calculated from the volume fraction $V_m$ of the matrix and the volume fraction $V_f$ of the filler by the formula

$$V_m \times CTE_m + V_f \times CTE_f = CTE_c$$

In the above formula, $V_m$ and $V_f$ are further constrained by the relation that $V_m + V_f = 1$. For epoxies, a typical CTE is approximately 50 PPM/ K. For zirconium tungstate, the CTE is approximately -7 ppm/ K. The above formula can be solved for the relative volume of the matrix to yield a zero CTE giving the following:

$$V_m = CTE_f /(CTE_f - CTE_m)$$

The volume fraction is the filler will be given by $1-V_m$.

For a matrix having CTE of 50 ppm/ K and a filler having a CTE of negative -7 PPM/ K, the above formula yields a volume fraction of the matrix of 7/57 and a volume fraction of the filler of 50/57 (0.88). This indicates that, for example, a composite having a net CTE of 0 (zero) may be formulated from such matrix and filler materials if the filler material makes up 88% of the volume of the composite. If the matrix has a CTE of 30 PPM/ K, the same calculation results in a composite having a CTE of about 0 (zero) if the volume fraction of filler particles in the composite is about 30/37 (81%). To reach a composite composition having a slightly higher CTE, such as would be necessary to match the CTE of commonly used semiconductor materials, slightly lower volume fractions of filler can be used. In one embodiment, the composite composition comprises at least 62%, preferably 65% or greater by volume filler. In another embodiment, the composition comprises greater than 72%, preferably 75% or greater by volume filler. These volume fractions are generally sufficient to formulate composite compositions having CTE's on the order of 0 to 7 ppm/K for an initial matrix of 30 ppm/K. For matrix materials that have CTEs greater than 30 ppm/ K, fill factors into the 80% to 90% range may be required.

It has been difficult to formulate prior art negative CTE materials into a composite composition having such high levels of filler. In retrospect, theoretical observations can shed light on why the difficulties arose. Conventional particles generally have a range of particle sizes distributed around an average particle size that is approximated by a normal distribution. In such distributions, there is a fairly narrow range of particle sizes, symmetrically centered about an average and characterized in addition by a standard deviation indicating the narrowness or breadth of the particle number distribution. Normal distributions are thus characterized by having an equal number of particles above and below the average particle size. The average particle size is also the mid-range of the distribution. In the limit where a normal particle number distribution is very narrow, one approaches the theoretical limit of a mono-size distribution. The theoretical maximum volume percent that can be occupied by spherical particles, all of which are the same size, is around 74%. In practice, if the particles are roughly spherical, it has been shown that mono-size distribution particles, or particles having a normal distribution approaching a mono-size distribution, are usually unable to be packed to a volume fraction of greater than about 64% in a composite. While not wishing to be bound by theory, it is believed that a wider, appropriately skewed, non-normal, distribution of the negative CTE particles of the invention permits them to be incorporated at levels in the composite higher than that achievable by conventional particles having a normal number distribution.

In a preferred embodiment, the filler particle distribution has a specified maximum particle size which is chosen in order to achieve the desired filler volume within the composite. The filler particle number distribution and the volume distribution derived from it should be chosen so that the volume distribution is increasing as the particle size increases while the number distribution is decreasing with increasing particle size. In a preferred embodiment, the increase of the volume distribution and the decrease of the number distribution are monotonic. Examples of distributions that contain some of these attributes include appropriately shaped log-normal, exponential, power-law, or multi-modal distributions. These are representative distributions that can be shaped to enable higher packing densities than can be achieved with normally-distributed particle sizes. One way of preparing non-normal distributions having the above characteristics is to truncate other normal or non-normal distributions. In a preferred embodiment, such other distributions may be truncated so that only particles with characteristic sizes less than the volume distribution mode are used. In this way, the requirement that the volume distribution decreases with decreasing particle size is satisfied. Such truncation may be conveniently carried out by, for example, sieving.

In another embodiment, filler compositions of the invention have a non-normal particle distribution in the sense that, in comparison to a normal distribution, the non-normal distributions of the invention have a relatively greater volume of the particles above the modal size of the distribution than below the modal of the distribution. It is believed that such a distribution provides particles with a wide range of diameters with appropriate number/volume distribution. Such particles may be thought of as roughly spherical in a simple model. In a spherical model, large size particles closely pack leaving interstices between the particles defined by the diameter of the large particle. For efficient packing into a composite, smaller particles are needed that are of sufficient size to fit within interstices defined by larger particles. Of course, in any real world distribution of particles, the simple model will not describe the situation entirely. In a real world distribution, there will be a range of larger particle sizes with a concomitant range of smaller particle sizes. In non-normal distributions skewed as it were to larger particle sizes, there will be in general pairs of particles having sizes relative to each other so that the smaller fits into interstices defined by close packing of the larger particles. The result will be an overall better packing into the available space, so that a greater fraction of the space is occupied by filler. According to this model, particle number distributions with a relatively higher weight- or volume fraction of particles above the mid-range of the distribution than below the mid-range will provide a range of particle sizes conducive to higher filling of a matrix in which they are formulated. Examples of non-normal particle number distributions for use in the invention include, but are not limited to, a log-normal distribution, an exponential distribution, and, in a preferred embodiment, a power-law distribution or a multi-modal distribution.

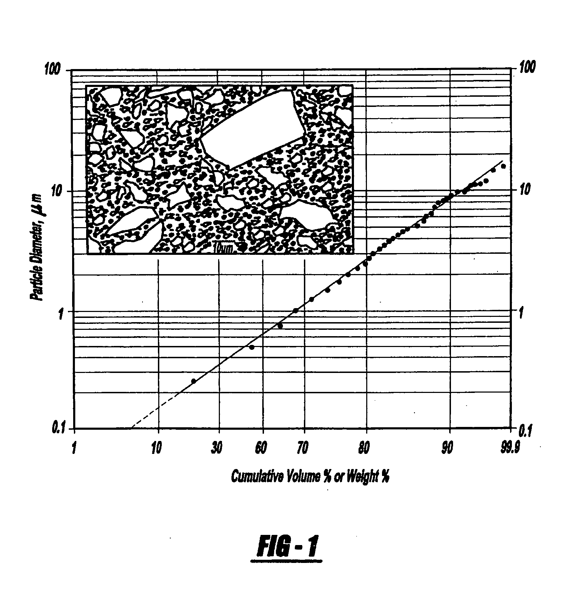

In one embodiment, the particles have a log normal volume distribution. Particles having a log normal volume distribution are characterized in that the logarithm of the particle size is distributed normally about a mean logarithmic particle size. One result is that a population of particles with a log-normal volume distribution, as with other non-normal volume distributions, can have a wider range of particle sizes simultaneously with a comparatively higher weight fraction of particles above the mid-range than the corresponding normal distribution. Figure 1 illustrates a cumulative log-normal weight (or volume) distribution according to the invention. In Figure 1, the log of a particle diameter is graphed on the Y axis while a weight percent function is on the X axis. The curve in Figure 1 represents the total weight percent of particles in the distribution having a particle size less than or equal to the indicated diameter on the Y axis. In a log-normal distribution, such a graph is linear, as can be seen in Figure 1. In a preferred embodiment, a plot of the logarithm of cumulative volume against the logarithm of particle size is linear over at least one order of magnitude of particle size, preferably over at least 1.5 orders of magnitude. The inset in Figure 1 illustrates the wide range of particle diameters present in such a particle mixture having a log-normal distribution.

Figure 1 illustrates a further desirable feature of the invention. Preferably, at least 30% by weight of the particles in the filler material is made up of particles with a size less than or equal to about 1 micron ($\mu$m). Preferably at least 40%, and more preferably at least 50% of the weight of the particles in the filler composition will be of a diameter less than 1 micron. Figure 1 illustrates a particular preferred embodiment where approximately 60% by weight of the particles in the filler composition have a diameter of 1 micron or less. In addition to having a significant fraction of the weight of the particles made up of particles less than 1 micron in diameter, it can be seen from Figure 1 that there is nevertheless a significant proportion of particles having larger diameters. As mentioned above, it is believed that this characteristic of a log-normal particle weight (or volume) distribution contributes toward the ability of the composites of the invention to be formed with high loading of filler.

In another aspect, the invention provides a method for formulating a filled composite having a low, zero, or negative coefficient of thermal expansion, comprising the steps of providing a filler composition and the matrix material, wherein the filler composition comprises particles of a material with a negative CTE and wherein the filler particles have a log-normal or other non-normal particle volume distribution. Thereafter. the composite is made by mixing the filler particles into the matrix. The mixing of the filler particles into the matrix may be carried out by conventional means. The particular means chosen to mix the filler particles into the matrix will vary depending on the equipment available and the nature of the matrix. In a non-limiting example of formulating filler particles into an epoxy matrix, a mixing procedure is given below.

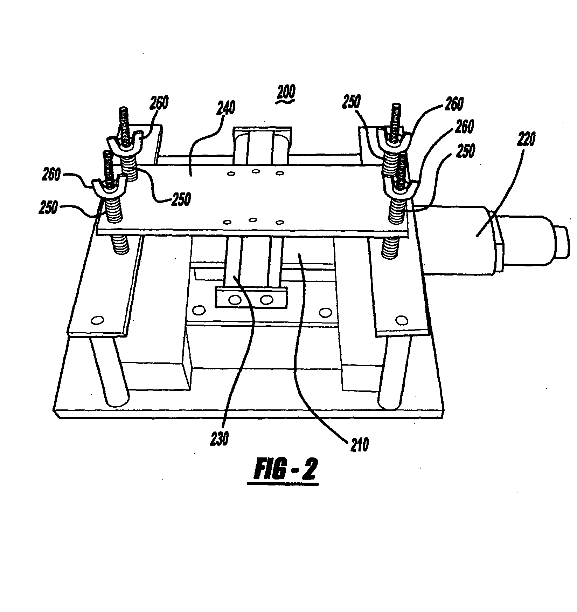

For example, a mixing procedure was developed using a two-roller linear actuator mixer to disperse zirconium tungstate throughout an epoxy matrix. Figure 2 illustrates the actuator mixer. The mixer 200 consists of a base plate 210 anchored to a linear actuator 220, two rollers 230 attached to a top plate 240, and four spring-loaded posts 250. The base plate 210 can be heated to and controlled at a desired temperature. The linear actuator 220, when engaged, moves the base plate 210 back and forth at a regular frequency. The rollers 230 may be similar to ink rollers and remain stationary during mixing. The rollers are capable of rotating to account for uneven thickness in the sample. The rollers and top plate can be pressed against the sample by tightening wing nuts 260 on the four posts 250. Mixing is carried out, for example with a device of Figure 2 in order to achieve the best possible dispersion of the negative CTE material, to minimize the formation of voids within the mixture, and to maintain uniform results from mix to mix.

Example 1

Example 1 - Zirconium tungstate having a log-normal volume distribution is mixed with an epoxy matrix material to form a composite according to the following procedure. Zirconium tungstate having an approximately log normal volume distribution may be purchased from Wah Chang. Part A of an epoxy is placed in a 100 mm wide nylon bag that has been heat sealed on one end. A weighed amount of zirconium tungstate is then placed in the nylon bag. The open end of the bag is then heat sealed, leaving a small amount of air in the bag to aide in mixing.

Using flash stripper tape at each heat-sealed end of the nylon bag, the bag is attached to the base plate of the mixer. Before mixing the sample, the base plate is heated to a temperature between 45°C and 50°C. This reduces the viscosity of Part A of the epoxy and aids in the dispersion of the particles.

The spring-loaded roller plate is now lowered on top of the sample to be mixed and the sleeves are tightened in order to maintain pressure on the sample while mixing. The linear actuator is engaged and the sample is allowed to mix for approximately 1 hour. After 1 hour, the mixer is switched off and the sample is removed from the base plate. While the next few steps are performed, the base plate is allowed to cool to room temperature.

Depending on where the sample resides in the nylon bag, it may be necessary to hand mix the sample for 2-3 minutes such as by using a blunt-edged nylon trowel in order to consolidate the mixture in one end of the bag. Then, the bag is cut open and the pre-weighed amount of Part B of the epoxy is added to the mixture. It is important to note the time so that the pot life is not exceeded before the mixture is poured into a mold for curing. After Part B is added, the bag is again heat-sealed as before, leaving a small amount of air in the bag.

The bag is again taped to the base plate of the mixer (which should have cooled to room temperature) and the roller plate is lowered onto the sample as before. Allow the sample to mix for approximately 15 minutes to ensure complete mixing of Part A and Part B. Depending on time constraint and other factors, some samples may be hand mixed at this stage using the nylon trowel.

After completion of this final mix, the nylon bag is again opened and placed, open end up, in a glass beaker. The beaker is then placed in a vacuum oven at room temperature and vacuum is applied. This step removes air bubbles from the mixture and prevents the formation of voids in the sample before, during, and after cure. The sample is left in the vacuum oven for approximately 10 minutes, removing the vacuum for 3 seconds every 2-3 minutes to prevent foaming. After this step, the beaker is removed from the oven and the mixture is now ready for test sample preparation. Alternatively, the formulated composite may be used directly to prepare electronic packages.

Example 2

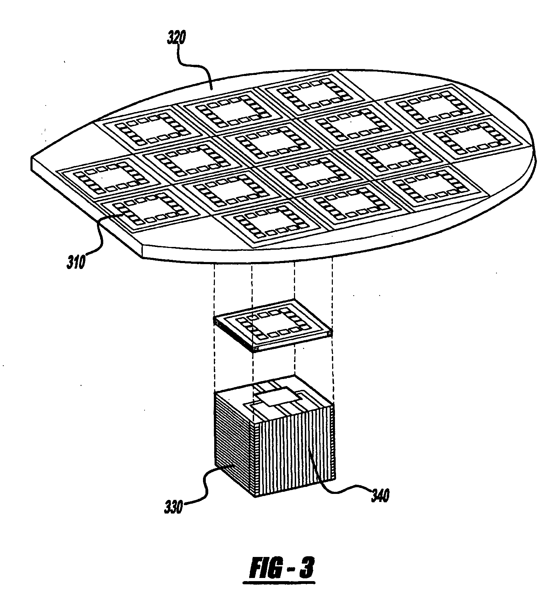

Example 2 illustrates the invention used to prepare a 3-D electronic device package known as a system in a cube (see Figure 3). Referring to Figure 3, chips 310 for layering are embedded side by side in an epoxy matrix 320 shaped like a silicon wafer. The layers are sliced out of the epoxy wafer and stacked into a module 330. Bus metal 340 is deposited on the outside of the stack 330 to bring the I/O from the chips to the cap chip. The epoxy matrix 320 contains a low CTE adhesive/encapsulant such as that prepared in Example 1 as a potting compound. Example 2 illustrates in part Irvine Sensors' Neo-Stack process as illustrated in IEEE Spectrum, August 2001, pages 46-51.

The invention has been described above with respect to preferred embodiments. It has been disclosed that an adhesive/encapsulant for assembling and packaging cryo-electronic and super-conductor devices, high power density, solid state and fiber lasers, fiber optic, and power electronic devices, and the like, may be formulated by preparing composites made with filler materials having a negative thermal expansion coefficient and logarithmic particle size distribution. A class of cubic structure compounds with important isotropic properties has been recently discovered with a large negative thermal expansion coefficient; the compounds are considered suitable for this application. The compounds include, without limitation, zirconium tungstate, hafnium tungstate, solid solutions thereof, and their oxides. In addition to their attractive thermal expansion properties, these compounds can be compatibly loaded into polymer resin such as epoxies to high concentrations needed to produce composite materials with expansion properties close to those of electronic and optical components. The large negative CTE property combined with their capability for being highly loaded in matrix resins permits attainment of an adhesive or encapsulant with a CTE of a few or even zero ppm per degree at practically achievable concentrations. When added and thoroughly dispersed in a polymer resin, the filler materials produce a composite material whose thermal expansion properties can be predicted according to a simple rule of mixtures law. Other materials with more moderate negative expansion coefficients may also be suitable for this application. Such materials include without limitation, faujasite ($SiO_2$), $LiAlSiO_4$, $PbTiO_3$, $Sc_2W_3O_{12}$, $Lu_2W_3O_{12}$, and $Al\,PO_4$. The invention permits the practical fabrication and packaging of large complex single and multi-layer electronic and photonic devices that need to operate reliably at extreme high and very low temperatures and/or withstand thermal cycling under more moderate temperature conditions. In one embodiment, an electronic package according to the invention is capable of operating at temperatures down to 4 K and below without experiencing debonding or delaminating. Because of the close match of the thermal expansion properties of the potting materials/encapsulant to the semiconductor material making up the integrated circuits, such electronic packages are also capable of repeated cycling from high to low temperatures without break down. The invention permits use of filled polymer composite adhesives and encapsulants with tailorable CTE properties to assemble and package electronic and optical circuits and passive components made from a wide variety of metal, ceramic, glass and semiconductor materials. Due to the reduced mismatch in CTE between components possible with the materials of this invention, these electronics/photonics elements may be scaled to much larger size, permitting more functionality or capability in the device. This scaling feature or capability enabled by the adhesive/encapsulant technology of the invention is important for the development of VLSI superconductor and cryo-electronic integrated technologies. For example, current superconductor IC technology is only at the LSI maturity level. The advanced assembly and packaging material of the invention may be used to progress the technology to the VLSI level.

The foregoing discussion discloses and describes merely exemplary embodiments of the present invention. One skilled in the art will readily recognize from such discussion and from the accompanying drawings and claims, that various changes, modifications and variations can be made therein without departing from the spirit and scope of the invention as defined in the following claims.

**Claims**

1. A filled composite composition, comprising a matrix and a filler composition, wherein the filler composition comprises particles of a material having a negative coefficient of thermal expansion, and wherein the particles exhibit a non-normal particle distribution **characterized by** a volume distribution and a number distribution, wherein the volume distribution monotonically increases as the particle size increases, and the number distribution monotonically decreases as particle size increases.

2. A composition according to claim 1, wherein the material having negative coefficient of thermal expansion comprises at least one material selected from the group consisting of zirconium tungstate, hafnium tungstate, and zirconium hafnium tungstate.

3. A composition according to claim 1, wherein the composite composition comprises at least 65 percent by volume filler.

4. A composition according to claim 1, wherein the composite composition comprises greater than 75 percent or greater by volume filler.

5. A composition according to claim 1, wherein the matrix comprises an organic epoxy resin.

6. A composition according to claim 1, wherein the matrix comprises an epoxy resin and the filler comprises zirconium tungstate.

7. A composition according to claim 1, wherein at least 50 percent by weight of the filler composition is made of particles with a size less than one micrometer.

8. A composition according to claim 1, wherein the matrix comprises a thermoset resin.

9. A composition according to claim 1, wherein the matrix comprises a thermoplastic resin.

10. A composition according to claim 1, wherein the particle volume distribution is log-normal.

11. A composition according to claim 1, wherein the particle volume distribution is exponential.

12. A composition according to claim 1. wherein the particle volume distribution is a power-law.

13. A composition according to claim 1, wherein the particle volume distribution is multi-modal.

**14.** An electronic package comprising a semiconductor chip in contact with a supporting nonconductive material, wherein the nonconductive material comprises a composition according to claim 1.

**15.** A method for formulating a filled composite having a low, zero, or negative coefficient of thermal expansion, comprising mixing a filler composition into a matrix, wherein the matrix comprises a thermoplastic or thermoset organic resin, and the filler composition comprises particles of material with a negative CTE, wherein the filler particles exhibit a non-normal particle number distribution **characterized by** a mode, wherein particles with a size greater than the mode contribute a larger volume fraction than the fraction contributed by particles with sizes above the mode of a normal distribution.

**16.** A method according to claim 15, wherein the material with a negative coefficient of thermal expansion comprises at least one compound selected from the group consisting zirconium tungstate, hafnium tungstate, and zirconium hafnium tungstate.

**17.** A method according to claim 15, wherein the matrix comprises a thermoset resin.

**18.** A method according to claim 17, wherein the thermoset resin comprises an A side and a B side, and wherein the mixing step comprises dispersing the particles in the A side, adding the B side to the dispersion of particles in the A side, and mixing for a further time period shorter than the hardening time of the resin.

**19.** An electronic package comprising a plurality of stacked chips made of semiconductor material and encapsulated in a potting material, wherein the encapsulating potting material comprises a matrix material and a filler composition, wherein the filler composition comprises particles of material having a negative coefficient of thermal expansion, and wherein the particles exhibit a non-normal particle number distribution **characterized by** a mode, wherein particles with a size greater than the mode contribute a larger volume fraction than the fraction contributed by particles with sizes above the mode of a normal distribution.

**20.** An electronic package according to claim 19, wherein the matrix comprises an epoxy resin.

**21.** An electronic package according to claim 19, wherein the material having a negative coefficient of thermal expansion is select from the group consisting of zirconium tungstate, hafnium tungstate, and zirconium hafnium tungstate.

**22.** An electronic package according to claim 20, wherein the electronic package can operate at temperatures down to 4 Kelvin and below without debonding or delaminating.

**23.** An electronic package according to claim 19, wherein the coefficient of thermal expansion of the encapsulating potting material essentially matches that of the semiconductor material.

**24.** A filled composite composition, comprising an organic matrix and an inorganic filler composition, wherein the composite composition comprises 65% or greater by volume filler, wherein the filler composition comprises particles of a material with a coefficient of thermal expansion less than 5 ppm/K, and wherein the particles are **characterized by** a particle distribution such that a plot of the logarithm of cumulative volume against the logarithm of particle size is linear over at least one order of magnitude of particle size.

**25.** A composition according to claim 24, wherein the matrix comprises a thermoset organic resin.

**26.** A composition according to claim 24, wherein the matrix comprises a thermoplastic organic resin.

**27.** A composition according to claim 24, wherein the filler composition comprises particles of a compound selected from the group consisting of zirconium tungstate, hafnium tungstate, and zirconium hafnium tungstate.

**28.** A composition according to claim 24, comprising 75% or greater by volume of the filler composition.

**29.** A composition according to claim 24, wherein the matrix comprises an epoxy resin and the filler composition comprises zirconium tungstate.

**30.** A composition according to claim 24, wherein 50% or greater by weight of the filler composition is made up of particles with a size less than 1 micrometer.

**31.** A composition according to claim 24, wherein the plot is linear over 1.5 orders of magnitude.

**32.** A composition according to claim 24, having a coefficient of thermal expansion of 7 ppm/K or less.

**33.** A composition according to claim 24, having a coefficient of thermal expansion of 3 ppm/K or less.

**34.** A composition according to claim 24, having a coefficient of thermal expansion of 0 ppm/K or less.

**35.** An electronic package comprising a plurality of stacked chips made of a semiconductor material and encapsulated in a potting material, wherein the potting material comprises a composition according to claim 24.

**36.** An electronic package comprising a plurality of stacked chips made of a semiconductor material and encapsulated in a potting material, wherein the potting material comprises a composition according to claim 28.

**37.** An electronic package comprising a plurality of stacked chips made of a semiconductor material and encapsulated in a potting material, wherein the potting material comprises a composition according to claim 29.

**38.** An electronic package comprising a plurality of stacked chips made of a semiconductor material and encapsulated in a potting material, wherein the potting material comprises a composition according to claim 30.

**39.** An electronic package according to claim 35, wherein the coefficient of thermal expansion of the potting material essentially matches that of the semiconductor material.

**FIG - 1**

FIG - 2

**FIG - 3**